(19) Europäisches Patentamt
European Patent Office
Office européen des brevets

(11) Publication number: **0 140 304 B1**

(12) **EUROPEAN PATENT SPECIFICATION**

(45) Date of publication of patent specification: **29.11.89**

(51) Int. Cl.[4]: **H 05 K 3/10,** H 01 L 29/28

(21) Application number: **84112635.2**

(22) Date of filing: **18.10.84**

(54) **Conductive patterns in polymeric films.**

(30) Priority: **19.10.83 US 543581**

(43) Date of publication of application:
**08.05.85 Bulletin 85/19**

(45) Publication of the grant of the patent:
**29.11.89 Bulletin 89/48**

(84) Designated Contracting States:
**AT BE CH DE FR GB IT LI LU NL SE**

(56) References cited:
**EP-A-0 031 444**
**EP-A-0 075 454**
**US-A-3 994 727**

**ELECTRONIC DESIGN, vol. 26. no. 16, August 1978, page 100; "International technology"**

(73) Proprietor: **PHILLIPS PETROLEUM COMPANY**
**5th and Keeler**
**Bartlesville Oklahoma 74004 (US)**

(72) Inventor: **Johnson, Timothy Walter**
**1520 S.E. Smysor Drive**
**Bartlesville, OK 74006 (US)**
Inventor: **Stone, Mark Lee**
**1513 S.E. East Drive**
**Bartlesville, OK 74006 (US)**

(74) Representative: **Dost, Wolfgang, Dr.rer.nat., Dipl.-Chem. et al**
**Patent- und Rechtsanwälte Bardehle-Pagenberg-Dost-Altenburg & Partner Postfach 86 06 20**
**D-8000 München 86 (DE)**

**EP 0 140 304 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to the formation of electrically-conductive paths in a polymeric object. It further relates to the selective modification of morphology in a polymeric film. In one embodiment, the invention relates to methods for preparing printed circuits boards, integrated circuits and other electrical devices. The EP—A—0031444 discloses an electrically conductive thermoplastic composition comprising a processible polymer—inter alia poly(phenylene sulfide)—and an electron acceptor or donor dopant.

The current practice for making conductive paths in such applications as printed circuit boards and integrated circuits generally fall into two categories. One is the etching from a completely conducting sheet the areas desired to be non-conducting. The other method is to metal-coat a substrate while preventing metal contact with non-conducting areas. Such a coating process usually involves plating or vacuum deposition of a metal. Simpler methods and less expensive materials are being sought for such applications.

It is therefore an object of the present invention to produce all-plastic electrical components such as printed circuit boards. It is a further object to provide a method for making conductive paths in a polymeric surface.

According to the invention, conductive paths on a polymeric surface are produced by selective alteration of the morphology of the polymer in selected areas and subsequent selective inducement of electrical conductivity. In a preferred embodiment of the invention method, a poly(arylene sulfide) film is made receptive to induced conductivity in selected areas, and conductivity is induced in those areas. For example, poly(arylene sulfide)s are receptive to chemical dopant-induced electrical conductivity in the amorphous state but not in the crystalline state. A film of a poly(arylene sulfide) is treated to selectively alter the polymer morphology at sites of desired conductivity or non-conductivity. An amorphous polymeric object can be made crystalline at selected sites of desired non-conductivity and conductivity induced in the untreated areas of the polymer. Alternatively, a crystalline polymer can be made amorphous at selected sites of desired conductivity and conductivity induced at the treated sites. The preferred method of inducing conductivity is chemical doping at the amorphous areas. The invention is useful for the production of printed circuit boards, integrated circuits and other applications requiring patterned electrical conductivity on a substrate.

The invention provides a method for producing conductive paths as defined in the claims. For reasons of their superior properties and the distinct difference in susceptibility to induced conductivity between the crystalline and amorphous states, poly(arylene sulfides) are advantageously used in this invention. A further embodiment of this invention resides in an article of poly(arylene sulfide) and its use as defined in the claims.

Crystallinity can be induced in an amorphous poly(arylene sulfide) by, for example, the action of certain solvents, the application of heat, or the use of high-intensity light such as a laser beam, as described below.

The poly(arylene sulfide) useful in the invention article of manufacture can be any polymeric material comprising one or more aryl moieties having sulfide linkages. Suitable starting materials for the polymer are disclosed in US Patents 3,354,129 and 3,919,177. Such polymers include those represented by the formula $(-R-S-)_n$ wherein R is a substituted or unsubstituted benzene ring and n is at least 50. The manufacture of poly(arylene sulfide) is known in the art. A polyhalosubstituted aromatic compound is reacted with a sulfur source in a polar organic solvent. In a commercial form of this process, para - dichlorobenzene is reacted with sodium sulfide in N - methylpyrrolidone solvent. A process for producing high molecular weight, film grade poly(phenylene sulfide) is described in U.S. Patent 3,919,177. According to the process described therein, p - dichlorobenzene is reacted with sodium sulfide in N - methylpyrrolidone solvent in the presence of an alkali metal carboxylate. The resulting polymer resin has a melt viscosity of 100 to 600,000 poise (10 to 60,000 Pa · s), preferably 300 to 100,000 poise (30 to 10,000 Pa · s) at 300°C and a shear rate of 200 $sec^{-1}$.

Suitable polyhalosubstituted aromatic compounds for producing poly(arylene sulfide) polymers and copolymers include 1,2 - dichlorobenzene, 1,3 - dichlorobenzene, 1,4 - dichlorobenzene, 2,5 - dichlorotoluene, 1,4 - dibromobenzene, 2,5 - dibromoaniline, 1,3,5 - trichlorobenzene, and the like.

The preferred polymer in terms of its availability and properties is poly(phenylene sulfide), in which R is an unsubstituted benzene ring. Poly(phenylene sulfide) is a thermoplastic polymer having a melting point of about 280° to 290°C. It is available in various forms as Ryton® poly(phenylene sulfide), a product of Phillips Petroleum Company.

The poly(arylene sulfide) of the invention can be a copolymer of two or more aromatic monomers. Referring to the general $(-R-S-)_n$ formula above, the predominate R group in a copolymer will generally be p - phenylene with relatively minor amounts of, for example, aryl moieties such as o - phenylene, m - phenylene, methyl - p - phenylene, dimethyl - p - phenylene, or p,p - biphenylene although these can also comprise the majority of the R groups in a poly(arylene sulfide) polymer. The linkages for the aromatic moieties can include functionalities in addition to sulfide groups

$$-\overset{\overset{\displaystyle O}{\|}}{C}- \text{ and } -O-,$$

for example. Illustrative of suitable poly(arylene sulfide) copolymers are polybiphenyl/phenylene sulfide, polyphenylene sulfide ketone, and poly(thianthrenylene sulfide).

Although the shape and dimensions of the article to be treated are not critical, it is believed that the present most promising utility of the invention lies in the treatment of a polymeric film or sheet having a thickness of from about 1 mil (0.025 mm) to about 60 mil (1.5 mm), generally about 1 mil (0.025 mm) to about 15 mil (0.38 mm) for film applications. The description of the process herein will, without limitation, be given in terms of the treatment of a film.

It is possible to treat an amorphous or crystalline polymeric film according to the invention method for producing selective conductivity. The receptivity of a poly(arylene sulfide) to chemical doping is dependent upon the degree to which the polymer is amorphous in structure; therefore, the relatively more crystalline areas of the film will be less conductive after doping of the material. Highly crystalline polymeric regions will be essentially non-conductive. Although "crystalline" and "amorphous" are relative terms, crystalline poly(phenylene sulfide) generally exhibits a crystallinity index (CI), as determined by x-ray diffraction, of about 20 to about 100, while the amorphous polymer exhibits a CI of about 0 to about 20.

The procedure will generally be employed to treat an amorphous poly(arylene sulfide) film by crystallizing designated areas and doping the remaining amorphous areas to produce a pattern of electrical conductivity in the uncrystallized areas. Crystallization of amorphous poly(arylene sulfide) can be effected by a variety of agents, including solvent action, heat and high intensity light. Among the solvents which are effective in producing crystallinity in amorphous poly(arylene sulfide) are dichloromethane, dichloroethane, chloroform, tetrahydrofuran and toluene. The conditions under which the solvent is employed to treat the polymer will vary depending upon the circumstances, but will generally include contact of the polymer with the solvent, including in appropriate cases immersion of the polymer in the solvent. The contacting can occur at room temperature and pressure, with contact time varying with the polymer and conditions. Suitable results will generally be achieved by, for example, contact with a solvent for about 0.5 minutes to about 5 hours under normal conditions.

Selective crystallinity can also be induced in an amorphous polymer by heating the polymer in the areas not chosen for conductivity. Generally, temperatures above about 150°C are effective for producing crystallinity in poly(phenylene sulfide), for example.

Alternatively, the poly(arylene sulfide) can be selectively crystallized by use of a high-intensity light beam such as a laser. Because of its ability to produce rapid, localized heating of the substrate, that is the presently preferred method for producing intricate patterns of conductivity on amorphous poly(arylene sulfide). Suitable conditions for such treatment will of course vary with the light source and other conditions, but will generally include a light intensity of about 0.1 joules/$cm^2$ to about 5 $J/cm^2$, with single or multiple pulses at about a 1 Hz repeat rate. The laser treatment can be carried out in air or other desired atmosphere. A pulsed carbon dioxide laser has been found effective in producing selective changes in crystallinity in poly(arylene sulfide).

It is also possible to use a crystalline poly(arylene sulfide) as the starting material for the invention process. Amorphous regions in a crystalline film can be produced by, for example, heating the regions and immediately quenching the heated polymer to freeze the amorphous state into the heated regions. Any method for quickly lowering the temperature of the heated polymer can be used, including immersion of the polymer in cold water. Gradual cooling of a polymer such as poly(phenylene sulfide), by contrast, results in the formation of a crystalline structure in the heated areas.

A presently preferred procedure for producing selected areas of amorphous poly(arylene sulfide) in a crystalline film is to attach the crystalline film to a backplate which can be cooled or refrigerated. The film affixed to the backplate is subjected to one or more pulses of high-intensity light such as produced by a pulsed $CO_2$ laser. The heat from the absorbed laser pulse(s) melts target areas of the film, and the cold backplate immediately quenches these areas into an amorphous state.

The polymer is then subjected to induced conductivity, such as contact with a chemical dopant. The amorphous areas are rendered conductive, and the crystalline areas remain non-conductive, thus producing an article exhibiting electrical conductivity over selected areas. Such a method of selectively inducing electrical conductivity has application in producing printed circuit boards and integrated circuits.

Example I

Eight samples of thin PPS film were rendered electroconductive by post-fabrication doping. The film used in this example was a high molecular weight slightly branched, poly(phenylene sulfide) having a flow rate of 50—70 g/10 min. The sample films varied in thickness from about 10 to 40 mils (0.25 to 1.0 mm). Initially the film had a crystallinity index of 5.0, indicating that it was essentially amorphous.

The dopant employed was nitrosonium hexafluorophosphate ($NOPF_6$) obtained from Ozark-Mahoning. $NOPF_6$ was added to a 70/30 volume ratio of nitromethane and methylene chloride. The doping solution was prepared under an inert atmosphere.

The doping procedure involved immersing the sample films in the doping mixture at room temperature. The doping was performed within a glove bag, and the doping mixture was stirred occasionally during the immersion period. Experimental conditions and results are shown in Table I.

After removal of the films from the doping solution, the samples were rinsed in pure nitromethane, and were then placed in a vacuum chamber and pumped dry. The conductivity of each sample was determined

by placing the sample into a specially-constructed sample holder which pressed two platinum contact wires each 1 cm long and separated by 1 cm onto the surface of the film. Using a potential of six volts, measured with a Kiethley 173A meter, the current passing through the sample was measured with a Kiethly model 610 electrometer. Resistance, bulk resistivity and bulk conductivity of each sample were calculated from the measured current.

TABLE I

| Experimental conditions | | | | | | Results |
|---|---|---|---|---|---|---|
| Sample number | $NOPF_6$ g/100 ml[1] | Doping time (min.) | CI[2] | Draw ratio[3] | Heat set | Conductivity ($\Omega^{-1}$ $cm^{-1}$) |
| 1 | 0.98 | 70 | — | — | — | $1.4\times10^{-2}$ |
| 2 | 0.71 | 30 | 15 | 2× | — | $3.0\times10^{-5}$ |
| | | +20 | | | | $9.0\times10^{-4}$ |
| 3 | 0.71 | 60 | 24 | 4× | — | $2.8\times10^{-7}$ |
| 4 | 1.48 | 60 | 18 | 0 | no | $1.4\times10^{-2}$ |
| 5 | 1.48 | 60 | 20 | 3.5× | no | $1.4\times10^{-5}$ |
| 6 | 1.48 | 60 | 84 | 3.5× | yes | $3.0\times10^{-9}$ |
| 7 | 1.55 | 60 | 66 | — | — | $2.5\times10^{-7}$ |
| 8 | 1.55 | 60 | 75 | — | — | too low to read |

[1]Added to a 70/30 by volume mixture of nitromethane/methylene chloride.
[2]Crystallinity Index measured using a x-ray diffraction technique.
[3]Certain of the samples were biaxially drawn.

Example II

A thin piece of basically-oriented, amorphous film was placed between two blocks of wood with holes drilled in them. The output of a heat gun was directed at the exposed portion of the film, causing it to crystallize. The crystallized state of the film was noted by observing the film through cross polarizers in a microscope. After exposure to the doping media, as in Example I, the regions of the film masked by the wood turned black and were quite conductive, whereas the heat treated portion of the film remained clear and non-conductive.

Example III

The output from a pulsed $CO_2$ laser was directed at a thin amorphous PPS film partially masked by a metal template having the word "MEMO" cut out of it. After 15 pulses, the mask was removed. The film was examined under a microscope using cross polarizers. Separate crystalline and amorphous regions could easily be distinguished. The film was doped as in Example I and the words appeared clear against a black conductive background.

Another piece of amorphous film was masked with a fine metal frame where the pattern in places was as narrow as 90 µm. After exposure to the laser and subsequent doping, clearly defined conductive lines were present.

Example IV

Thin pieces of crystalline film were attached to a large test tube filled with air, ice water, or dry ice. The exposed areas were heated by a pulsed laser beam and quenched by the cool tube, yielding amorphous regions of polymer in an otherwise crystalline film. The films were doped and only the laser treated areas turned black and conductive ($10^{-2}$ to $10^{-3}$ $ohms^{-1}cm^{-1}$).

Example V

Even finer conductive lines were produced on PPS film, utilizing the electron beam of a scanning electron microscope (SEM) to convert the initially crystalline film to the amorphous form. Pieces of thin highly crystalline film were masked in a variety of patterns and metal contact pads were deposited in a

vacuum metallizing apparatus. The films were transferred to the SEM. At a current of 5 to $9\times10^{-8}$ A, the sample was moved back and forth for 10 min under the beam in such a way so as to connect two metal contact pads with the line drawn by the beam. Upon doping, only the life became black and conductive. The line varied in thickness from about 0.03 to 0.08 mm.

Example VI

Solvent control of morphology was utilized to produce crystallinity patterns in a PPS film. Simple tape masks applied to the film prior to painting the film with methylene chloride were effective in controlling the areas of solvent-induced crystallization. After the solvent treatment the tape was removed and the samples doped in the usual fashion. A variety of conductive lines, figures and shapes were produced using this technique.

**Claims**

1. A method for producing conductive paths on a poly(arylene sulfide) objective comprising:

altering the polymer morphology of selected areas of the object so as to produce in such areas relatively lesser polymer crystallinity; and

selectively inducing electrical conductivity in said areas of lesser polymer crystallinity.

2. The method of claim 1 characterized in that said electrical conductivity is selectively induced by chemical doping of the areas of lesser polymer crystallinity; in particular using a doping agent in a liquid solvent effective for increasing the crystallinity of the poly(arylene sulfide); in particular by doping the areas of relatively lesser polymer crystallinity with nitrosonium hexafluorophosphate; in particular in which the nitrosonium hexafluorophosphate is present in a liquid effective for increasing the crystallinity of the poly(arylene sulfide).

3. The method of any of the preceding claims characterized in that the polymer morphology is altered by heating the selected areas to a temperature above the melting temperature of the poly(arylene sulfide); in particular in which the polymer morphology is altered by a solvent effective for reducing the crystallinity of the poly(arylene sulfide); in particular in which the polymer morphology is altered by contact of the selected areas with a high-intensity light beam; in particular in which the polymer morphology is altered by contact of the poly(arylene sulfide) with a pulsed carbon dioxide laser beam.

4. The method of any of the preceding claims characterized in that the selected areas exhibit a crystallinity of less than about 15, as determined by x-ray, after alteration of the polymer morphology.

5. A method for producing conductive paths on a poly(arylene sulfide) film comprising:

contacting selected areas of the poly(arylene sulfide) film with a pulsed laser beam having an intensity of at least about 0.1 joules/$cm^2$ so as to heat the selected areas to a temperature above the melting point of the poly(arylene sulfide);

cooling the selected areas so as to produce in the selected areas a crystallinity different from that of the non-heated areas of the poly(arylene sulfide) film; and

chemically doping those areas of the thus-treated poly(arylene sulfide) film having a relatively lower level of crystallinity with a doping agent effective to increase the electrical conductivity of the doped areas of the poly(arylene sulfide).

6. The method of claim 5 characterized in that the areas contacted with the pulsed laser beam are quenched so as to produce areas of relatively low crystallinity in the poly(arylene sulfide); or in which the areas contacted with the pulsed laser beam are cooled so as to produce areas of relatively high crystallinity in the poly(arylene sulfide).

7. The method of claim 5 characterized in that the step of contacting selected areas of a poly(arylene sulfide) film with a pulsed laser beam is carried out while simultaneously contacting the opposite side of the film with a substrate having a temperature effective for reducing the temperature of the film at a rate which will freeze thus-heated areas in an amorphous polymeric state.

8. An article of manufacture comprising a poly(arylene sulfide) film, the film comprising (a) regions of amorphous poly(arylene sulfide), (b) regions of crystalline poly(arylene sulfide), and (c) a chemical doping agent present in the regions of amorphous poly(arylene sulfide).

9. The article of manufacture of claim 8 characterized in that the chemical doping agent is as defined in claim 2; in particular in which the chemical doping agent is confined to the regions of amorphous poly(arylene sulfide).

10. The method or article of any of the preceding claims characterized in that the poly(arylene sulfide) is poly(phenylene sulfide).

11. The use of the article of claim 8 or 9 as a printed circuit board or integrated circuits.

**Patentansprüche**

1. Verfahren zur Herstellung von leitfähigen Bahnen auf Poly - (arylensulfid) - Gegenständen, umfassend:

das Verändern der Polymermorphologie von ausgewählten Bereichen des Gegenstands, um in diesen Bereichen eine geringere Polymerkristallinität zu erzeugen; und

das selektive Induzieren von elektrischer Leitfähigkeit in diesen Bereichen von geringerer Polymerkristallinität.

2. Verfahren nach Anspruch 1, dadurch gekennzeichnet, dass die elektrische Leitfähigkeit selektiv induziert wird, indem man die Bereiche von geringerer Polymerkristallinität chemisch dotiert; insbesondere unter Verwendung eines Dotierungsmittels in einem zur Erhöhung der Kristallinität des Poly - (arylensulfids) wirksamen flüssigen Lösungsmittel; insbesondere durch Dotieren der Bereiche von relativ geringerer Polymerkristallinität mit Nitrosoniumhexafluorophosphat; wobei insbesondere das Nitrosoniumhexafluorophosphat in einer zur Erhöhung der Kristallinität des Poly - (arylensulfids) wirksamen Flüssigkeit vorliegt.

3. Verfahren nach einem der vorstehenden Ansprüche, dadurch gekennzeichnet, dass die Polymermorphologie verändert wird, indem man die ausgewählten Bereiche auf eine Temperatur über die Schmelztemperatur des Poly - (arylensulfids) erwärmt; wobei insbesondere die Polymermorphologie durch ein zur Verringerung der Kristallinität des Poly - (arylensulfids) wirksames Lösungsmittel verändert wird; wobei insbesondere die Polymermorphologie durch Kontakt der ausgewählten Bereiche mit einem Lichtstrahl hoher Intensität verändert wird; wobei insbesondere die Polymermorphologie durch Kontakt des Poly - (arylensulfids) mit einem gepulsten Kohlendioxid - Laserstrahl verändert wird.

4. Verfahren nach einem der vorstehenden Ansprüche, dadurch gekennzeichnet, dass die ausgewählten Bereiche nach Veränderung der Polymermorphologie eine Kristallinität von weniger als etwa 15, bestimmt durch Röntgenstrahlen, aufweisen.

5. Verfahren zur Herstellung von leitfähigen Bahnen auf einem Poly - (arylensulfid) - Film, umfassend:

das Kontaktieren von ausgewählten Bereichen des Poly - (arylensulfid) - Films mit einem gepulsten Laserstrahl mit einer Intensität von mindestens etwa 0,1 Joules/$cm^2$, um die ausgewählten Bereiche auf eine Temperatur über den Schmelzpunkt des Poly - (arylensulfids) zu erwärmen;

das Abkühlen der ausgewählten Bereiche, um in den ausgewählten Bereichen eine Kristallinität zu erzeugen, die sich von der Kristallinität von nicht-erwärmten Bereichen des Poly - (arylensulfids) - Films unterscheidet; und

das chemische Dotieren der Bereiche des auf diese Weise behandelten Poly - (arylensulfids) - Films von relativ geringerem Kristallinitätsgrad mit einem zur Erhöhung der elektrischen Leitfähigkeit der dotierten Bereiche des Poly - (arylensulfid) - Films wirksamen Dotierungsmittel.

6. Verfahren nach Anspruch 5, dadurch gekennzeichnet, dass die mit dem gepulsten Laserstrahl in Kontakt gebrachten Bereiche abgeschreckt werden, um Bereich von relativ geringer Kristallinität im Poly - (arylensulfid) zu erzeugen; oder bei dem die mit dem gepulsten Laserstrahl in Kontakt gebrachten Bereiche abgekühlt werden, um Bereiche von relativ hoher Kristallinität im Poly - (arylensulfid) zu erzeugen.

7. Verfahren nach Anspruch 5, dadurch gekennzeichnet, dass die Stufe des Kontaktierens von ausgewählten Bereichen eines Poly - (arylensulfid) - Films mit einem gepulsten Laserstrahl durchgeführt wird, während gleichzeitig die entgegengesetzte Seite des Films mit einem Substrat in Kontakt gebracht wird, das eine Temperatur aufweist, die zur Verringerung der Temperatur des Films mit einer Geschwindigkeit, die die auf diese Weise erwärmten Bereiche in einem amorphen polymeren Zustand einfriert, wirksam ist.

8. Fertigungsgegenstand, enthaltend einen Poly - (arylensulfid) - Film, wobei der Film (a) Bereiche aus amorphem Poly - (arylensulfid), (b) Bereiche aus kristallinem Poly - (arylensulfid) und (c) ein chemisches Dotierungsmittel, das in den Bereichen des amorphen Poly - (arylensulfids) vorliegt, umfasst.

9. Fertigungsgegenstand nach Anspruch 8, dadurch gekennzeichnet, dass das chemische Dotierungsmittel der Definition von Anspruch 2 entspricht, wobei insbesondere das chemische Dotierungsmittel auf die Bereiche von amorphem Poly - (arylensulfid) begrenzt ist.

10. Verfahren oder Gegenstand nach einem der vorstehenden Ansprüche, dadurch gekennzeichnet, dass es sich bei dem Poly - (arylensulfid) um Poly - (phenylensulfid) handelt.

11. Verwendung des Gegenstands nach Anspruch 8 oder 9 als gedruckte Schaltung oder in integrierten Schaltungen.

**Revendications**

1. Procédé de production de chemins conducteurs sur un objet de poly(sulfure d'arylène), comprenant:

la modification de la morphologie du polymère dans des régions choisies de l'objet de manière à produire dans ces régions une cristallinité du polymère relativement inférieure; et

la production sélective d'une conductibilité électrique dans ces régions de moindre cristallinité du polymère.

2. Procédé de la revendication 1, caractérisé en ce que cette conductibilité électrique est provoquée sélectivement par dopage chimique des régions de moindre cristallinité du polymère; en particulier en utilisant un agent dopant dans un solvant liquide efficace pour augmenter la cristallinité du poly(sulfure d'arylène); en particulier en dopant les régions de moindre cristallinité du polymère avec de l'hexafluorophosphate de nitrosonium; en particulier dans lequel l'hexafluorophosphate de nitrosonium est présent dans un liquide efficace pour augmenter la cristallinité du poly(sulfur d'arylène).

3. Procédé suivant l'une quelconque des revendications précédentes, caractérisé en ce que la morphologie du polymère est modifiée en chauffant les régions choisies à une température supérieure à la

température de fusion du poly(sulfure d'arylène); en particulier dans lequel la morphologie du polymère est modifiée par un solvant efficace pour réduire la cristallinité du poly(sulfur d'arylène); en particulier dans lequel la morphologie du polymère est modifiée par contact des régions choisies avec un pinceau de lumière de haute intensité; en particulier dans lequel la morphologie du polymère est modifiée par contact du poly(sulfure d'arylène) avec un faisceau laser au gaz carbonique pulsé.

4. Procédé suivant l'une quelconque des revendications précédentes, caractérisé en ce que les régions choisies présentent, après modification de la morphologie du polymère, une cristallinité, telle que déterminée par les rayons X, inférieure à environ 15.

5. Procédé de production de chemins conducteurs sur un film de poly(sulfure d'arylène) comprenant:

la mise en contact de régions choisies du film de poly(sulfure d'arylène) avec un faisceau de laser pulsé ayant une intensité d'au moins environ 0,1 Joule/$cm^2$ de manière à chauffer les régions choisies à une température supérieure au point de fusion du poly(sulfure d'arylène);

le refroidissement des régions choisies de manière à produire dans les régions choisies une cristallinité différente de celle des régions non chauffées du film de poly(sulfure d'arylène); et

le dopage chimique des régions du film de poly(sulfure d'arylène) ainsi traité ayant un taux de cristallinité relativement plus faible par un agent dopant efficace pour augmenter la conductibilité électrique des régions dopées du poly(sulfure d'arylène).

6. Procédé de la revendication 5, caractérisé en ce que les régions mises en contact avec le faisceau de laser pulsé sont trempées de manière à produire des régions de cristallinité relativement faible dans le poly(sulfure d'arylène); ou dans lequel les régions mises en contact avec le faisceau de laser pulsé sont refroidies de manière à produire des régions de cristallinité relativement élevée dans le poly(sulfure d'arylène).

7. Procédé de la revendication 5, caractérisé en ce que le stade de mise en contact de régions choisies d'un film de poly(sulfure d'arylène) avec un faisceau de laser pulsé est effectué tout en mettant simultanément en contact le côté opposé du film avec un substrat ayant une température efficace pour réduire la température du film à une vitesse qui gèlera les régions ainsi chauffées dans un état polymère amorphe.

8. Article manufacturé comprenant un film de poly(sulfure d'arylène), le film comprenant (a) des régions de poly(sulfure d'arylène) amorphe, (b) des régions de poly(sulfure d'arylène) cristallin, et (c) un agent de dopage chimique présent dans les régions de poly(sulfure d'arylène) amorphe.

9. Article manufacturé de la revendication 8, caractérisé en ce que l'agent de dopage chimique est tel que défini dans la revendication 2; en particulier dans lequel l'agent de dopage chimique est confiné aux régions de poly(sulfure d'arylène) amorphe.

10. Procédé ou article suivant l'une quelconque des revendications précédentes, caractérisé en ce que le poly(sulfure d'arylène) est un poly(sulfure de phénylène).

11. Utilisation de l'article des revendications 8 ou 9 comme plaque pour circuits imprimés ou dans des circuits intégrés.